# EUROPEAN PATENT APPLICATION

(11) **EP 1 635 454 A1**
(43) Date of publication of application: **15.03.2006**
(21) Application number: 04745811.2
(22) Date of filing: 11.06.2004
(51) Int. Cl.: H03F 1/26, H03F 3/19, H01L 27/08, H01L 29/78

(54) **LOW-NOISE AMPLIFIER**

(30) Priority: 13.06.2003 JP 2003170106
(71) Applicant: KABUSHIKI KAISHA TOYOTA JIDOSHOKKI, Kariya-shi, Aichi-ken 448-8671 (JP); Niigata Seimitsu Co., Ltd., Jyoetsu-shi, Niigata 943-0834 (JP); OHMI, Tadahiro, Sendai-shi, Miyagi 980-0813 (JP)
(72) Inventor: OHMI, Tadahiro, Sendai-shi, Miyagi 9800813 (JP); NISHIMUTA, Takefumi, Kariya-shi, Aichi 04488671 (JP); MIYAGI, Hiroshi, Joetsu-shi, Niigata 9430834 (JP); SUGAWA, Shigetoshi, Sendai-shi, Miyagi 9800861 (JP); TERAMOTO, Akinobu, Sendai-shi, Miyagi 9830037 (JP)
(74) Representative: TBK-Patent
(86) International application number: PCT/JP2004/008217
(87) International publication number: WO 2004/112238

(57) **Abstract**

A low noise amplifier is assumed to comprise an MIS transistor and to amplify an input signal keeping noise at a low level, and the MIS transistor comprises a semiconductor substrate for comprising a first crystal plane as a principal plane, a semiconductor structure, formed as a part of the semiconductor substrate, for comprising a pair of sidewall planes defined by the second crystal plane different from the first crystal plane and a top plane defined by the third crystal plane different from the second crystal plane, a gate insulator of uniform thickness covering the principal plane, the sidewall planes and the top plane, a gate electrode for continuously covering the principal plane, the sidewall planes and the top plane on top of the gate insulator, and a single conductivity type diffusion area formed in the region to either side of the gate electrode in the semiconductor substrate and the semiconductor structure and continuously extending along the principal plane, the sidewall planes and the top plane.

Such a configuration allows significant reduction of the 1/f noise and the signal distortion applied to an output signal by the low noise amplifier and therefore a circuit for compensating for the reduction of the amplitude is no longer of necessity, allowing reduction in size.

## Description

### Technical Field

The present invention relates to a low noise amplifier configured on a MIS (Metal Insulator Semiconductor) integrated circuit.

### Background Art

As a technology for extracting a desired frequency from a radio-frequency (RF) signal, a super heterodyne system and a direct conversion receiving system etc. are well known.
An explanation of a typical signal demodulation system is provided below, using the drawings, with an example of a direct conversion receiving system among these receiving systems.

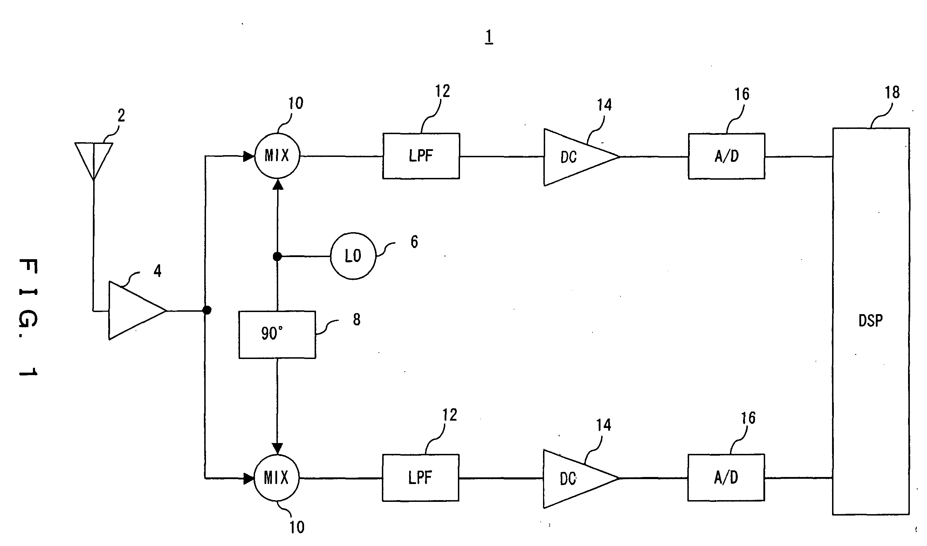

Fig. 1 is a circuit block diagram showing a commonly used direct conversion receiving system.
The circuit block diagram 1 in Fig. 1 comprises an antenna 2, a low noise amplifier 4, a local oscillator 6, a 90-degree phase shifter 8, a mixer 10, a low-pass filter (LPF) 12, a DC amplifier 14, an A/D converter 16 and a DSP 18.

Upon receiving an RF signal from the antenna 2 in Fig. 1, the RF signal is amplified by the low noise amplifier 4, and the amplified RF signal is provided to the mixers 10 configured at the top and bottom of Fig. 1.
Also, a local (LO) signal with the same frequency as the above RF signal is output from the local oscillator 6, and the LO signals are input to each mixer 10 each having a phase different from the other of 90-degrees as a result of the 90-degree phase shifter 8.

In the mixer 10, the above input RF signal and LO signal are multiplied, and the output of the low noise amplifier 4 is converted into base band signals with an in-phase (I) element and a quadrature (Q) element. According to this system, because the IF is zero, the base band signals overlap completely and cannot be demodulated, quadrature demodulation is performed using the two LO signals with phases differing from one another by 90-degrees and two mixer 10 units as explained above.

The signals output from the mixers 10, in the later stages, have unnecessary frequency components cut by the LPF 12, the desired frequency components output from the LPF 12 are amplified by a DC amplifier 14, and the output signal from the DC amplifier 14 is converted into a digital signal by the A/D converter 16.

By inputting the digital signal converted by the A/D converter 16 to the DSP 18, processing such as code regeneration is performed.
On the other hand, when the receiving system is a super heterodyne receiving system, a carrier frequency signal received by the antenna is converted into an intermediate frequency (IF) signal and therefore, an image frequency remains. For that reason, a band-pass filter is configured to remove the image frequency in the case of the super heterodyne receiving system in the stage before the low noise amplifier, and additionally an intermediate frequency filter etc., which limits the bandwidth of the extracted intermediate frequency, is configured in the IF circuit.

As it is clear from the explanation of the circuit block diagram, the low-noise amplifier, firstly serves as a circuit block with gain.
Because the noise figure of a low-noise amplifier is added to the noise figure of the system, how the noise can be reduced and the input signal can be amplified is a crucial point in designing a low-noise amplifier.

In recent years, the well know problems of the low speed and large noise of MOS (Metal Oxide Semiconductor) transistors have been improved upon, and thus by applying a MOS transistor to the above low-noise amplifier, the low-noise amplifier can be integrated on a semiconductor substrate.

As an example of a configuration of a semiconductor device with a single MIS transistor of a single conductivity type (p-channel or n-channel) configured on a semiconductor substrate, a configuration with its gate insulator film being an example, dry thermal oxidation processing is applied to and configured on a projecting part of a semiconductor substrate and is disclosed in Japanese laid-open disclosure public patent bulletin No. 2002-110963. According to the configuration, channels can be formed on a sidewall plane of the above projecting part of the semiconductor substrate.
Patent Document 1: Japanese laid-open disclosure public patent bulletin No. 2002-110963

However, if configuring a low-noise amplifier using the above MOS transistor, noise that is generated in a channel becomes prominent, proving that it is a direct cause of the increasing noise figure of a low-noise amplifier. The noise is flicker noise (1/f noise) generated by generation or recombination of electron-hole pairs, capture of a carrier by a trap, or release of a carrier from a trap etc. in a channel generated on or around the interface of the semiconductor substrate and the gate insulator. And it was difficult to reduce the 1/f noise.

In the saturation region of the transistor characteristics, it is desirable that the drain current indicates a constant value without depending on the voltage between the drain and the source; however in practice, the channel length modulation effect, in which an effective gate length is reduced whereas drain current is increased, occurs by shift of a pinch-off point (a point where channel carrier density becomes approximately 0) in the saturation region. For that reason, it was difficult to obtain a stable signal without distortion as an amplified signal.

As described above, in designing a low-noise amplifier, a challenge is how the noise can be reduced and the gain can be increased, and conventionally, a configuration such that noise and distortion affecting an output signal is compensated for by another circuit was required.

Additionally, in a low-noise amplifier with a CMOS configuration, it was a problem that parasitic capacitance of the p-channel MOS transistor and that of the n-channel MOS transistor do not agree with each other, generating signal distortion by the difference between rise and decay characteristics of the drain current corresponding to the voltage between the gate and the sources.

### Disclosure of the Invention

It is an object of the present invention to provide a low-noise amplifier, which enables reduction of noise with a small number of parts and signal amplification with high gain, and to provide, also, a low-noise amplifier with a CMOS structure, which enables reduction of signal distortion as well as noise, and the circuit has the following configuration.

One mode of the low noise amplifier of the present invention is assumed to comprise a MIS (Metal Insulator Semiconductor) transistor and to amplify an input signal (for example, a carrier signal) keeping noise at low level, and the MIS transistor comprises a semiconductor substrate for comprising a first crystal plane as a principal plane, a semiconductor structure, formed as a part of the semiconductor substrate, for comprising a pair of sidewall planes defined by the second crystal plane different from the first crystal plane and a top plane defined by the third crystal plane different from the second crystal plane, a gate insulator of uniform thickness for covering the principal plane, the sidewall planes and the top plane, a gate electrode for continuously covering the principal plane, the sidewall planes and the top plane on top of the gate insulator, and a single conductivity type diffusion region formed in one side and the other side of the gate electrode in the semiconductor substrate and the semiconductor structure and continuously extending along the principal plane, the sidewall planes and the top plane (conductivity type is n-type or p-type for example, and the single conductivity type diffusion region means that the regions, formed both sides of the above gate electrode, have diffusion regions of the same conductivity type).

Another mode of the low-noise amplifier of the present invention is assumed to comprise a MIS transistor and to amplify an input signal keeping noise at a low level, and the MIS transistor is a three-dimensional MIS transistor, comprising a semiconductor substrate with a projecting part of which the surfaces are at least two different crystal planes on a principal plane, a gate insulator for covering at least a part of each of said at least two different crystal planes constituting the surface of the projecting part, a gate electrode comprised by the gate insulator so as to be electrically insulated from the semiconductor substrate, and comprised on each of said at least two different crystal planes constituting the surface of the projecting part, and a single conductivity type diffusion region formed in the projecting part facing each of said at least two different crystal planes constituting the surface of the projecting part and individually formed on both sides of the gate electrodes.

Another mode of the low-noise amplifier of the present invention is assumed to comprise an MIS transistor and to amplify an input signal keeping noise at a low level, and the MIS transistor, comprising a semiconductor substrate with at least two crystal planes, a gate insulator formed on at least two of the crystal planes on the semiconductor substrate, and a gate electrode formed on the semiconductor substrate sandwiching the gate insulator, in which when voltage is applied to the gate electrode, a channel width of a channel formed in the semiconductor substrate along with the gate insulator is represented by summation of each channel width of the channels individually formed on said at least two crystal planes.

In each of the above modes of the low-noise amplifier of the present invention, it is desirable that the MIS transistor that comprises the semiconductor substrate is a silicon substrate and that a gate insulator on a surface of the silicon substrate, is formed by removing hydrogen in a way that the surface of the silicon substrate is exposed to plasma of a prescribed inert gas, and the hydrogen content at the interface of the silicon substrate and the gate insulator is 10¹¹/cm² or less in units of surface density.

It is also desirable that said at least two crystal planes are any two different crystal planes from the (100) plane, the (110) plane and the (111) plane.
Further, it is desirable that a CMOS transistor, configured in an n-channel MOS transistor and a p-channel MOS transistor, is comprised, and at least one of the n-channel MOS transistor or the p-channel MOS transistor comprises the MIS transistor of any one low noise amplifier of the above modes.

At that time, it is desirable that element areas and the current driving capacity of the p-channel MOS transistor and the n-channel MOS transistor closely agree with each other.
In the low noise amplifier with the above configuration, it is also possible to have such a configuration that an input voltage based on the input signal is mutually applied to the gate of the p-channel MOS transistor and that of the n-channel MOS transistor, the voltage source is configured on the drain side of the p-channel MOS transistor, the source of the p-channel MOS transistor and the drain of the n-channel MOS transistor are mutually connected, a direct current feedback circuit for determination of an operating point is connected between the source and the drain of the n-channel MOS transistor, and the voltage, which is present on the connection line mutually connecting the source of the p-channel MOS transistor and the drain of the n-channel MOS transistor, is output as amplified voltage of the input voltage.

The low noise amplifier in each of the above modes can be used in the direct conversion receiving system.
In the low noise amplifier of the present invention, a gate width is formed along with said at least two different crystal planes. Therefore, when voltage is applied to the gate, channels are formed along with the above said at least two different crystal planes. And when channels are formed along with the crystal plane of the projecting part in particular, the gate length modulation effect generated in each transistor can be well controlled.

The MIS transistor is characterized in that the semiconductor substrate is a silicon substrate and that a gate insulator on a surface of the silicon substrate is formed by removing hydrogen in a way that the surface of the silicon substrate is exposed to plasma of a prescribed inert gas, and the hydrogen content at the interface of the silicon substrate and the gate insulator is 10¹¹/cm² or less in units of surface density, and for this reason, the Dit at midgap of the interface of the semiconductor substrate and the gate insulator can be lowered, and reduction of the 1/f noise and variation in electrical characteristics of each transistor can be achieved.

In addition, said at least two of the crystal planes by combining any two different crystal planes from the (100) plane, the (110) plane and the (111) plane, at least two of the crystal planes substantially reduce the 1/f noise and variation in electrical characteristics.

The application of the above low noise amplifier to the direct conversion receiving system prevents the influence of the 1/f noise and signal distortion etc. generated from the low noise amplifier from being imparted to circuits in later stages.
In addition, a mixer circuit comprising a CMOS (Complementary Metal Oxide Semiconductor) transistor, in which current driving capacity and element area of the n-channel MOS transistor agrees with that of the p-channel MOS transistor can be configured.

### Brief Description of the Drawings

The present invention will be more apparent from the following detailed description in conjunction with the accompanying drawings, in which:
Fig. 1 is a circuit block diagram of a conventional direct conversion receiving system;
Fig. 2 is a cross-sectional diagram showing an example of a plasma processing device using a radial line slot antenna;
Fig. 3 is an analysis result of silicon-hydrogen bonding on a silicon substrate 103 by an infrared spectrograph;
Fig. 4 is a relationship between pressure in a processing chamber and thickness of an oxide film formed when gas pressure in the processing chamber 101 is varied while keeping the pressure ratio of Kr/O₂ at 97/3 in the processing chamber;
Fig. 5 is a diagram comparing the growth rate of a Kr/O₂ plasma oxide film with the growth rate of a dry thermal oxide film;
Fig. 6 is a diagram comparing the Dit at midgap of the Kr/O₂ plasma oxide film with that of the dry thermal oxide film;
Fig. 7A shows drain voltage versus normalized drain current characteristic;
Fig. 7B shows drain voltage versus normalized drain current characteristic;
Fig. 7C shows drain voltage versus normalized drain current characteristic;
Fig. 8 is an example of a configuration of an n-channel MOS transistor;
Fig. 9 is an example of a configuration of a CMOS transistor;
Fig. 10 is a diagram of a part extracted from Fig. 9;
Fig. 11 is an example of circuit of the low noise amplifier using the CMOS configuration; and
Fig. 12 is a circuit block diagram of the direct conversion receiving system.

### Best Mode for Carrying Out the Invention

In the following description, details of a preferred embodiment of the present invention are set forth with reference to the accompanying drawings.
A low noise amplifier of a preferred embodiment of the present invention is comprised of transistors with MIS (Metal Insulator Semiconductor) structure. In the embodiment of the present invention, a gate insulator of the MIS transistor is formed by adopting a gate insulator thin film formation technique, which is disclosed in Japanese laid-open unexamined patent publication No. 2002-261091.

For the above gate insulator, a nitride film or an oxynitride film can be used as described in the Japanese laid-open unexamined patent publication No. 2002-261091; however, the present embodiment is explained making an example of a MOS (Metal Oxide Semiconductor) transistor (MOSFET etc., for example) with the oxide film as its gate insulator.

First, an explanation of a gate insulator thin film formation method of the MOS transistor is provided.

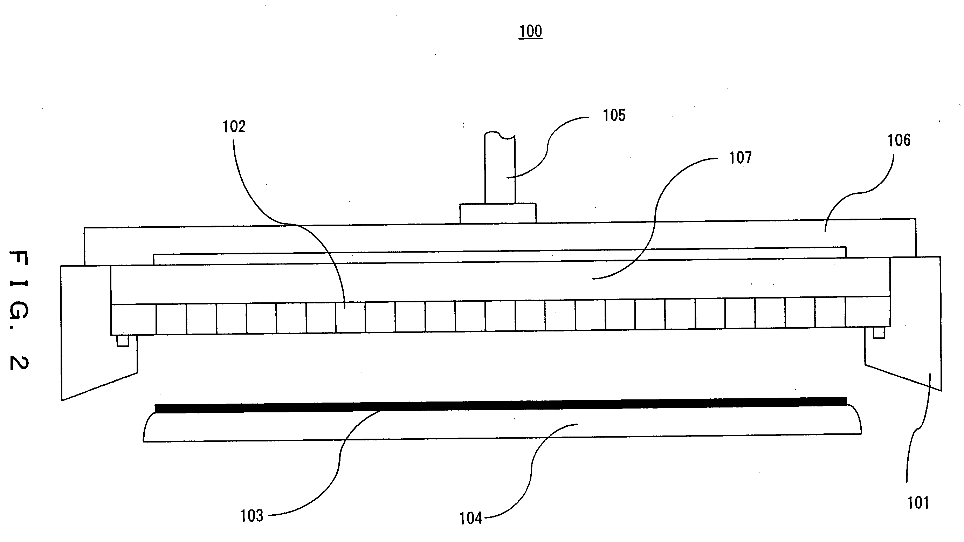

Fig. 2 is a cross-sectional diagram showing an example of a plasma processor device 100 using a radial line slot antenna.

In the gate insulator thin film formation method, in order to remove hydrogen terminating the dangling bonds of the silicon (indicated as Si) surface, surface terminating hydrogen removal processing and oxidation processing are carried out sequentially in the same processing chamber using Kr as a plasma excitation gas in the subsequent oxide film formation process.

First, a vacuum vessel (processing chamber) 101 is evacuated, Ar gas is introduced into the vessel from a shower plate 102, and later the introduced gas is changed to Kr gas. Air pressure in the vacuum processing chamber 101 is set around 133 Pa (1 Torr).

Next, a silicon substrate 103 is placed on a sample holder 104 with a heating mechanism and the temperature of the sample is set around 400°C. If the temperature of the silicon substrate 103 falls within the range of 200-550°C, the result described below would be almost the same. The silicon substrate 103 is treated with diluted hydrofluoric acid cleaning in the immediately preceding pretreatment processing step, and as a result, the dangling bonds of silicon on the surface are terminated with hydrogen.

Next, 2.45GHz microwaves are provided from a coaxial waveguide 105 to a radial line slot antenna 106, and microwaves are emitted in the processing chamber 101 from the radial line slot antenna 106 via a dielectric plate 107 configured on a part of the wall of the processing chamber 101. The emitted microwaves excite the Kr gas introduced from the shower plate 102 into the processing chamber 101, and high-density Kr plasma is formed directly below the shower plate 102. If the frequency of the provided microwaves is approximately within the range from 900MHz to 10GHz, the results explained below are almost the same.

In the configuration shown in Fig. 2, the distance between the shower plate 102 and the substrate 103 is set at 6cm in the present embodiment. A shorter distance between the two enables higher speed film formation.
Although the present embodiment shows an example of film formation using a plasma device with a radial line slot antenna, other methods can be used to excite plasma by emitting microwaves within the processing chamber.

By exposing the silicon substrate 103 to the plasma excited by the Kr gas, the surface of the silicon substrate 103 receives low-energy Kr ion irradiation, and the terminating hydrogen on the surface is removed.

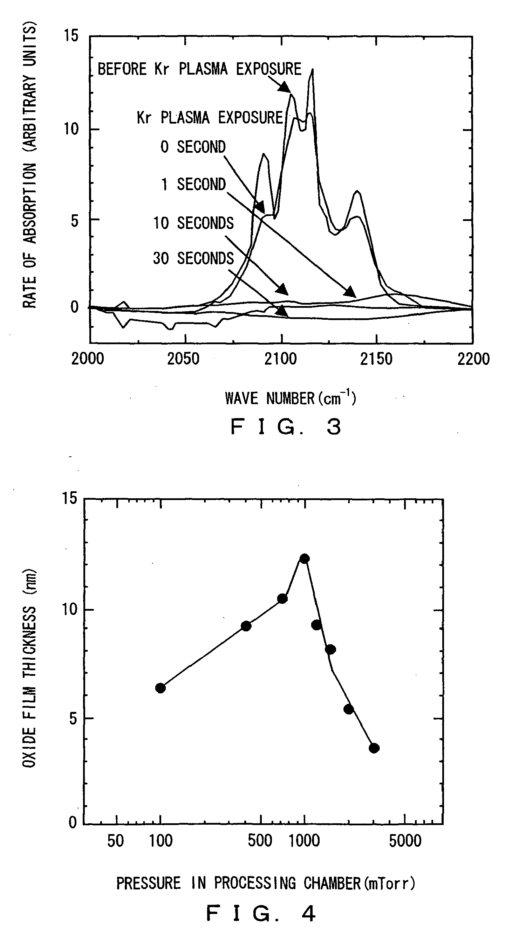

Fig. 3 shows a result of analysis of silicon-hydrogen bonding on the silicon substrate surface by an infrared spectrograph, and shows the removal effect of the terminating hydrogen on the silicon surface by the Kr plasma excited by emitting microwaves with a power density of 1.2W/cm² under 133 Pa (1 Torr) pressure in the processing chamber 101.

Reference to Fig. 3 discloses that only 1 second of Kr plasma irradiation causes most of the optical absorption in the vicinity of a wave number of 2100cm⁻¹, which is a characteristic of the silicon-hydrogen bond, to disappear, and with approximately 30 seconds of irradiation, the optical absorption disappears almost completely. In other words, approximately 30 seconds of Kr plasma irradiation can remove hydrogen terminating the silicon surface. In the present embodiment, Kr plasma irradiation is continued for 1 minute and completely removes the terminating hydrogen on the surface.

Next, a Kr/O₂ gas mixture with a partial pressure ratio of 97/3 is introduced from the shower plate 102. In so doing, the pressure in the processing chamber is maintained at around 133 Pa (1 Torr). In high-density excitation plasma in which Kr gas and O₂ gas are mixed, Kr*, which is in an intermediate excitation state, and O₂ molecules collide, effectively generating a large amount of atomic oxygen O*.

In the present embodiment, the surface of the silicon substrate 103 is oxidized by this atomic oxygen O*. The use of the present thin film formation method enables oxidation processing by the atomic oxygen at the significantly low temperature of around 400°C. In order to increase the chance of Kr*- O₂ collisions, it is desirable for the processing chamber to have a high pressure; however, if it is too high, the generated O* collide with one another and become O₂ molecules again. Therefore, there is an optimal gas pressure.

Fig. 4 shows the relationship between the thickness of the formed oxide film and the pressure in the processing chamber in a case where, maintaining the pressure ratio of Kr/O₂ at 97/3 within the processing chamber, the gas pressure within the processing chamber 101 is changed. In Fig. 4, the temperature of the silicon substrate 103 is set at 400°C, and the oxidation processing is carried out for 10 minutes.

Reference to Fig. 4 reveals that the oxidation rate is highest when the pressure within the processing chamber 101 is around 133 Pa (1 Torr), and thus this pressure or pressure conditions around this pressure are optimal. The optimal pressure is not limited to the case that the plane orientation of the silicon substrate 103 is the (100) plane, but is the same for any silicon surface with any plane orientation.

When silicon oxide film of a desired film thickness is formed, application of microwave power is stopped and then the plasma excitation is terminated. Additionally, the Kr/O₂ gas mixture is replaced by Ar gas, and then the oxidation process is completed. The Ar gas is used before and after the present process as a purge gas, which is less costly than Kr. The Kr gas used for the present process is to be recovered and recycled.

Following the above Kr/O₂ plasma oxide film formation, a semi-conductor integrated circuit device comprising a MOS transistor and a capacitor can be completed after an electrode formation process, a protective film formation process, and a hydrogen sintering processing process etc.

When the hydrogen content in units of surface density within a 3nm thick silicon oxide film formed by the above procedure was measured by thermal desorption analysis, the results were around 10¹²/cm² or less. It is confirmed that the hydrogen content in units of surface density within the silicon oxide film is around 10¹¹/cm² or less in an oxide film with particularly low leakage current. On the other hand, the oxide film, which was not exposed to the Kr plasma before the oxide film formation contained hydrogen at over 10¹²/cm² in units of surface density.

Measurement of roughness of a silicon surface after exfoliating the silicon oxide film formed by the above procedure, by an atomic force microscope and comparison with that of silicon roughness before oxide film formation confirmed that the roughness of the silicon surface remains unchanged. In other words, the silicon surface does not increase in roughness after removal of terminating hydrogen and oxidation.

According to the present gate insulator thin film formation method, hydrogen, remaining at the interface between a silicon substrate and a silicon oxide film formed as the gate insulator of a MOS transistor, is removed, and the interface is flattened. By such flattening, a low Dit at midgap at the interface can be attained, and favorable electrical characteristics (low leakage current characteristics, low Dit at midgap, high voltage resistance, high hot carrier resistance, constant threshold voltage characteristics etc.) can be acquired even though the gate insulator is thinned. Additionally, in the case of a gate insulator with an arbitrary plane orientation, favorable electrical characteristics can still be acquired from the plane orientation.

Next, an example of a MOS transistor formation using not only the (100) plane but also the (111) plane and the (110) plane of a silicon substrate in the above gate insulator thin film formation method is described.

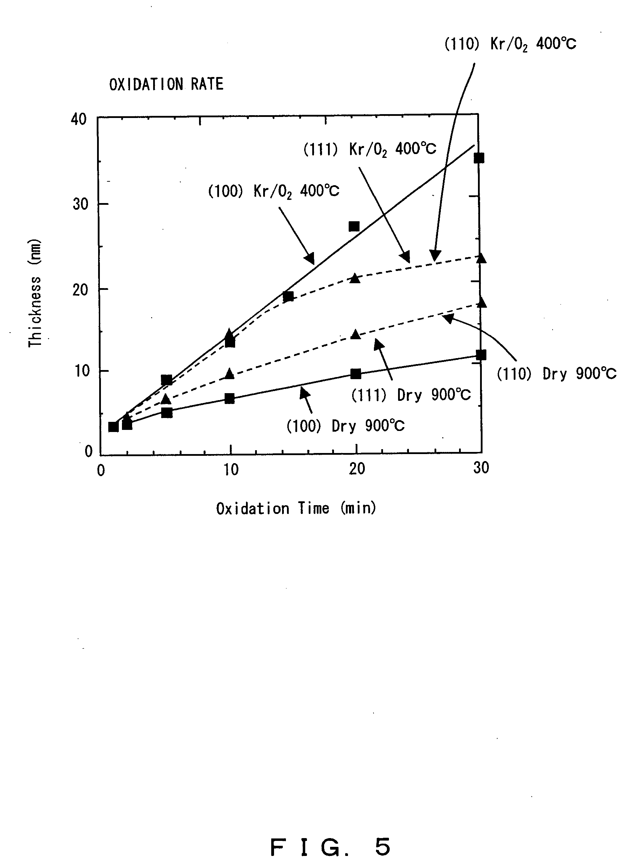

Fig. 5 shows the growth rate of a Kr/O₂ plasma oxide film, when oxidizing the (100) plane, the (111) plane and the (110) plane of a silicon substrate with the plasma processing device 100 of Fig. 2, in comparison with the growth rates of a dry thermal oxide films.

Reference to Fig. 5 shows that the Kr/O₂ plasma oxide film yields a much higher growth rate than the dry thermal oxide film, oxidation of an Si substrate using active atomic oxygen O* proceeds efficiently. In addition, it is understood from Fig. 5 that for the (111) plane and the (110) plane, of which the Si atom surface density is greater than the (100) plane, lower growth rate is yielded than for the (100) plane. This is in agreement with the conclusion derived from the material supply rate determining process; therefore the result suggests that the plasma oxide film formed in such a manner has a superior film quality.

Conversely, when forming dry thermal oxide films on the (111) and the (110) planes of Si substrate, the growth rate of the oxide film is higher than the growth rate when forming a dry thermal oxide film on the (100) plane, suggesting that the film quality of the dry thermal oxide film formed on the (111) plane and the (110) plane is inferior.

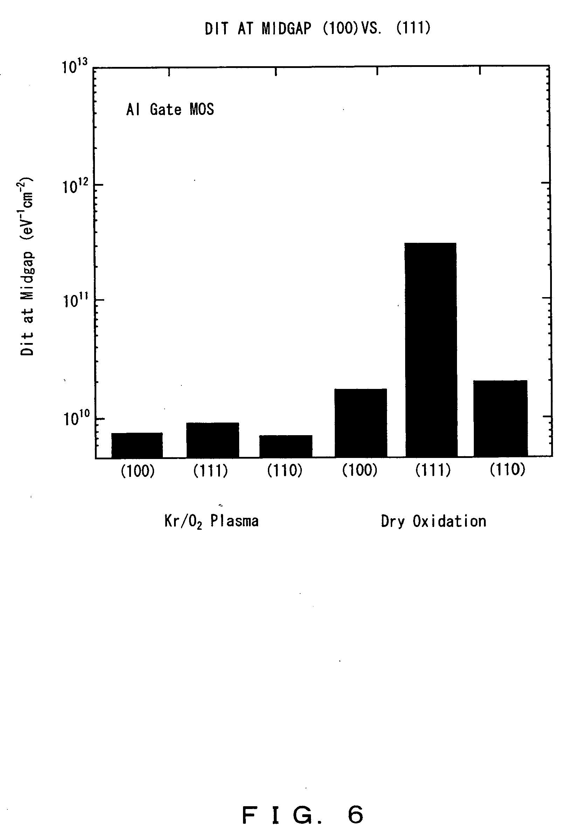

Fig. 6 shows comparison results of the Dit at midgap of the Kr/O₂ plasma oxide film formed as above and that of dry thermal oxide films.
Reference to Fig. 6 discloses that the Dit at midgap of the Kr/O₂ plasma oxide film formed on the (100) plane of a silicon and the Kr/O₂ plasma oxide film formed on the (111) plane of a silicon and the (110) plane of a silicon are all lower than those of the dry thermal oxide film formed on the (100) plane of a silicon, and an oxide film with extremely high quality can be acquired.

Conversely, a dry thermal oxide film formed on the (111) plane of a silicon and the (110) plane of a silicon has an extremely high Dit at midgap as predicted from the result in Fig. 5, and it is possible that various problems may be caused such as change in threshold voltage by carrier capture and increase in gate leakage current when used as a gate insulator of an MOS transistor.

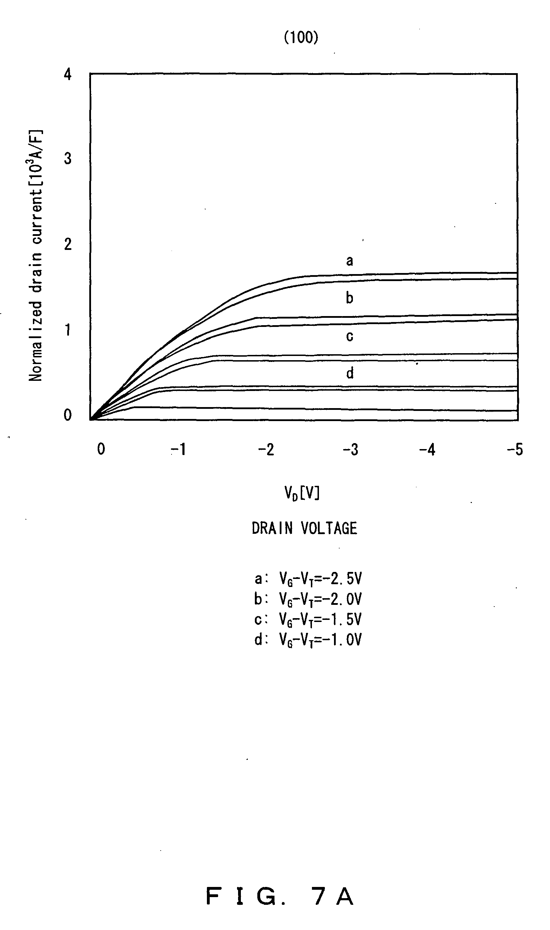

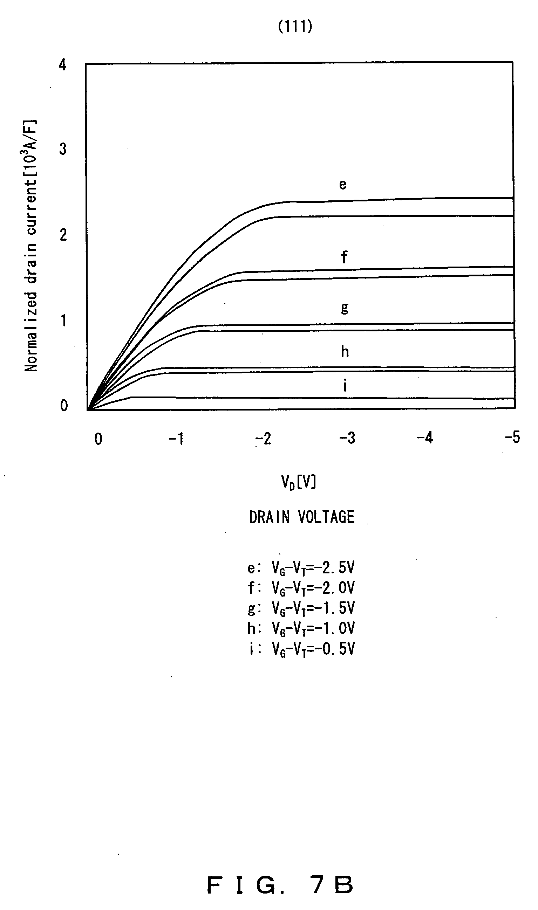

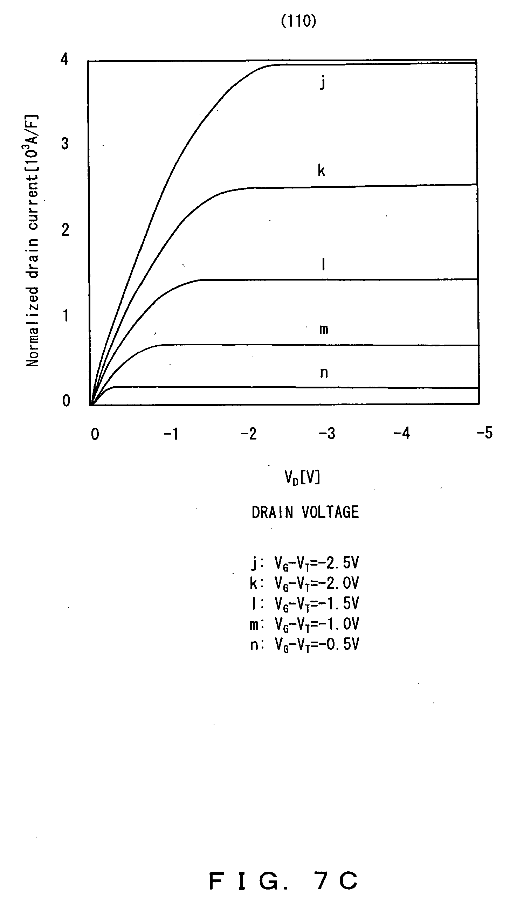

The Fig. 7A-Fig. 7C show the relationship between the drain voltage and the normalized drain current when a silicon oxide film is formed on the (100) silicon substrate surface, the (111) plane of a silicon substrate and the (110) plane of a silicon substrate, respectively, by the plasma processing device 100 of Fig. 2 and a p-channel MOS transistor with the silicon oxide film as a gate insulator is formed. Fig. 7A and Fig. 7B show both the cases where silicon oxide film is formed by Kr/O₂ plasma processing and where silicon oxide film is formed by dry thermal oxidation processing. In Fig. 7C, however, because an oxide film is not formed on the (110) plane by the dry thermal oxidation process, only the example of a gate oxide film formed by the Kr/O₂ plasma processing is shown. The result of Fig. 7A is of a p-channel MOS transistor with a gate length of 10µm and a gate width of 50µm, and the results in Fig. 7B and Fig. 7C are of a p-channel MOS transistor with a gate length 10µm and a gate width of 300µm.

Reference to Fig. 7A-Fig. 7C show that it is possible to increase the drain current of the p-channel MOS transistor, that is mutual conductance or current driving capacity, by forming a transistor on any crystal surface except for the (100) plane of a silicon such as the (111) plane or the (110) plane, to acquire a current driving force of about 1.3 times as much as that of the p-channel MOS transistor formed on the (100) plane when the p-channel MOS transistor is formed on the (111) plane of a silicon, and to acquire a current driving force of about 1.8 times as much as that of the p-channel MOS transistor formed on the (100) plane when the p-channel MOS transistor is formed on the (110) plane of a silicon.

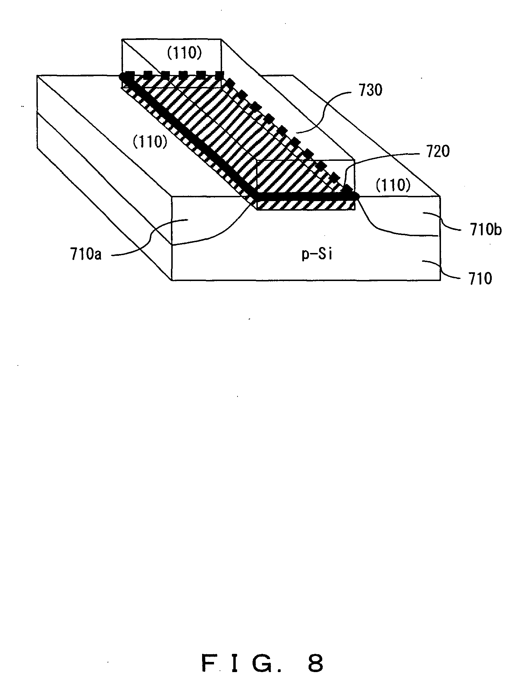

Fig. 8 is an example of a configuration of an n-channel MOS transistor.
The n-channel MOS transistor shown in Fig. 8 has a silicon oxide film evenly formed on the surface of a Si substrate 710 with a principal plane of the (110) plane, by the plasma processing device 100 explained in Fig. 2, and a polysilicon gate electrode 730 is produced on the formed silicon oxide film. Patterning is applied to the silicon oxide film along with patterning of the gate electrode 730, and a gate insulator 720 is formed in a region surrounded by the bold line and the broken line corresponding to the gate insulator 730 in Fig. 8.

The n-type diffusion regions 710a and 710b are formed on both sides of the gate electrode 730 by performing ionic implantation of an n-type impurity using the gate electrode 730 as a self-aligning mask. As a result, an n-channel MOS transistor is formed on the Si substrate 710. In Fig. 8, when a channel is formed between the n-type diffusion regions 710a and 710b, the range of the formation is indicated by the shaded area.

Fig. 8 is an example of a configuration of an n-channel. MOS transistor; however by forming p-type diffusion regions on both sides of the gate electrode by performing ionic implantation of a p-type impurity using the gate electrode as self-aligning mask, a p-channel MOS transistor can be formed on a Si substrate.

In the MOS transistor configured as above, low Dit at midgap can be acquired at the interface of the (100) crystal plane of the Si substrate and the gate oxide film; therefore 1/f noise can be reduced, and favorable electrical characteristics can be stably acquired.

For that reason, a more stable MOS transistor with reduced variation in electrical characteristics between elements can be configured.
In the above configuration example, a transistor was formed on the (110) plane of a Si substrate; however when the transistor is formed on other planes such as the (100) plane and the (111) plane the above effect can still be obtained.

Next, unlike the case of configuring a transistor only a crystal plane in one orientation such as the (110) plane, an example of configuring a transistor (three-dimensional structure) using a plurality of orientations simultaneously is described.

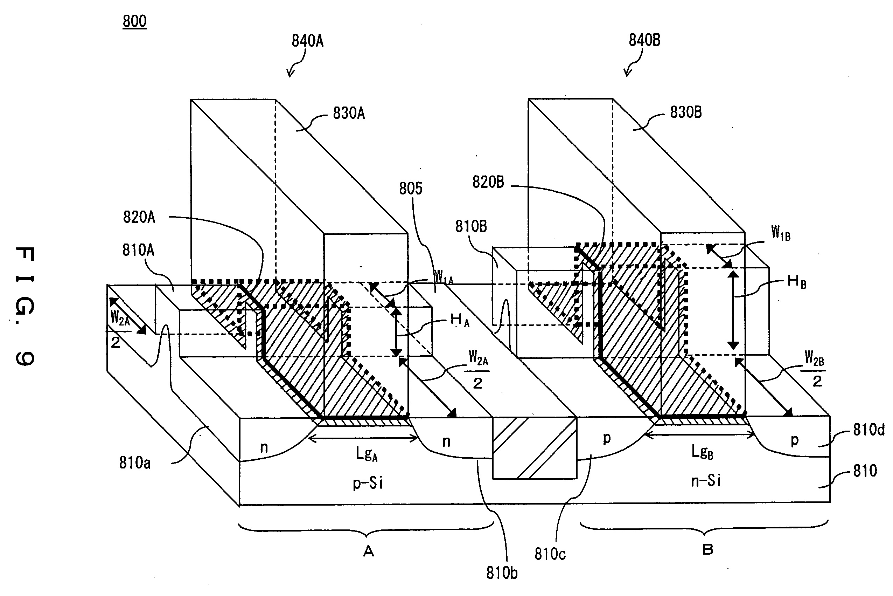

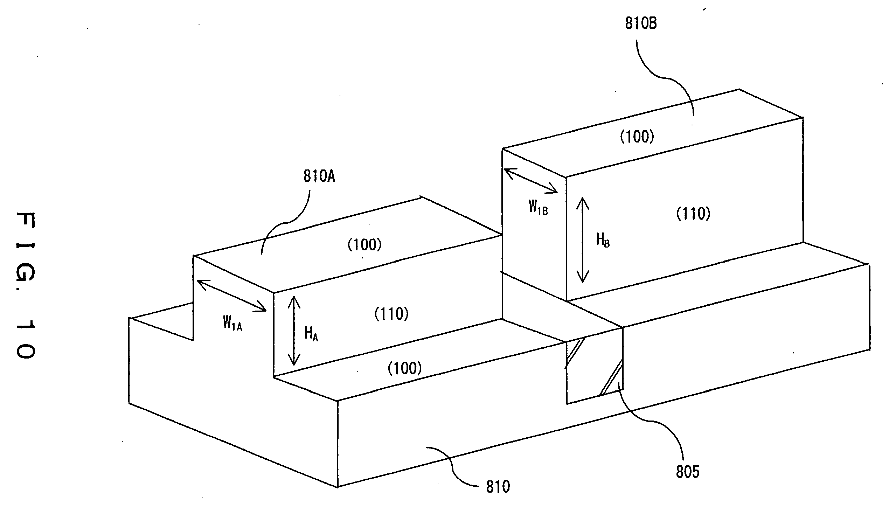

Fig. 9 and Fig. 10 are an example of a CMOS (Complementary Metal Oxide Semiconductor) transistor comprising a p-channel MOS transistor and an n-channel MOS transistor.

Fig. 10 is a diagram extracted from a part of Fig. 9.
Reference to Fig. 9 and Fig. 10 shows that a CMOS transistor 800 is formed on a Si substrate 810, having a principal plane of the (100) plane where a n-type region A and a p-type region B, separated by a element separation region 805, are formed, and as shown in Fig. 10, the region A, comprising a projecting part 810A with a width of W_{1A} and a height of H_{A}, and the region B, comprising a projecting part 810B with a width of W_{1B} and a height of H_{B}, are formed on the walls of both sides. As can be seen from Fig. 10, the top surface of the projecting parts 810A and 810B is defined by the (100) plane and the side surface is defined by the (110) plane.

A silicon oxide film is evenly formed on the Si substrate 810 in Fig. 10 by the plasma processing device 100 described in Fig. 2, and on top of the film, polysilicon gate electrodes 830A and 830B shown in Fig. 9 are formed on the region A and on the region B, respectively. Following patterning of the gate electrodes 830A and 830B, patterning is applied to the silicon oxide film, a gate insulator 820A corresponding to the gate electrode 830A and a gate insulator 820B corresponding to the gate electrode 830B are formed in the shaded areas surrounded by a bold line in Fig. 9.

Additionally, in the CMOS transistor 800 in Fig. 9, by performing ionic implantation of the n-type impurity using the gate electrode 830A as a self-aligning mask in the n-type region A, n-type diffusion regions 810a and 810b having the projecting part 810A are formed on both sides of the gate electrode 830A. Similarly, in the p-type region B, p-type diffusion regions 810c and 810d having the projecting part 810B are also formed on both sides of the gate electrode 830B. As a result, on the Si substrate 810, an n-channel MOS transistor 840A is produced in the region A and a p-channel MOS transistor 840B is produced in the region B.

In the CMOS transistor 800 described in the present embodiment, the n-channel MOS transistor 840A has a gate length L_{gA} and the p-channel MOS transistor 840B has a gate length L_{gB}, the gate electrode 830A covers a flat part of the Si substrate 810 at either side of the projecting part 810A over a gate width of W_{2A}/2. As a result, the gate width on the (100) plane of the gate electrode 830A, including the top part of the gate on the projecting part 810A, can be expressed as W_{1A}+W_{2A}. On the other hand, the gate width on the (110) plane of the gate electrode 830A formed on both side walls is expressed by 2H_{A}, and accordingly, the current driving capacity of the n-channel MOS transistor 840A formed on the region A is expressed by the equation µₙ₁(W1A+W2A)+2µₙ₂H_{A}, where µₙ₁ represents the electron mobility of the (100) plane and µₙ₂ represents the electron mobility of the (110) plane.
In a similar way, the current driving capacity of the p-channel MOS transistor 840B, formed on the region B, can be expressed by the equation µₚ₁(W_{1B}+W_{2B})+2µₚ₂H_{B}, where µₚ₁ represents the hole mobility of the (100) plane and µₚ₂ represents the hole mobility of the (110) plane.

In such a manner, low Dit at midgap can be realized at the interface of the (100) crystal plane of the Si substrate and the gate oxide film, and thus the 1/f noise can be reduced, and favorable electrical characteristics can be stably acquired. In addition to the (100) plane, which is the principal plane of the Si substrate 810, a gate can be produced with a different plane orientation, that is the (110) plane, as described above; therefore, it is possible to reduce the element area by reducing the gate width in the principal plane and compensating by adjusting the gate width of the part of the gate with a principal plane formed on the (110) plane. Consequently, it is possible to reduce the size of a transistor element.

In the above example, the transistor on the sidewall is formed on both sides of the wall; however it may be formed only on one side.
A configuration with the above H_{A} of 0 is also possible.

In Fig. 9, ranges where channels are formed along with each of the gate insulators 820A and 820B between the n-type diffusion regions 810a and 810b, or between the p-type diffusion regions 810c and 810d on top of the Si substrate are indicated as shaded areas. As is clear from Fig. 9, the width of the channel formed in the Si substrate along with the above gate insulator is equal to the summation of the above W_{1A} + W_{2A} of the (100) plane and 2H_{A} of the (110) plane in a case of the n-channel MOS transistor 840A, for example, or is equal to the summation of the above W_{1B} + W_{2B} of the (100) plane and 2H_{B} of the (110) plane in a case of the p-channel MOS transistor 840B, for example.

Therefore, if H_{A} and H_{B} are determined so as to satisfy the equations of W_{1A}+W_{2A}=W_{1B}+W_{2B} and µₙ₁(W_{1A}+W_{2A})+2µₙ₂H_{A}=µₚ₁(W_{1A}+W_{2B})+2µₚ₂H_{A}, it is possible to configure a CMOS transistor with an n-channel MOS transistor and a p-channel MOS transistor such that their element area and current driving capacity agree.

Three-dimensional formation of the channels, as shown in the shaded area of Fig. 9, allows control of reduction of the effective gate length based on the shift of the pinch-off point (the point where the channel carrier density becomes approximately 0) in channels formed on one plane and increase of the drain current in the saturation region.

As a result, signal distortion of a signal amplified by an MOS transistor can be reduced.
The embodiment shows an example of a configuration of a CMOS transistor. However, obviously, it is possible to construct a non-complementary type configuration, that is a configuration with either the n-channel MOS transistor 840A alone or the p-channel MOS transistor 840B alone, three-dimensionally using the (100) plane and the (110) plane as described above. Also, unsurprisingly, such a configuration with either the n-channel MOS transistor or the p-channel MOS transistor can achieve the same effect as described above.

As above, the 1/f noise is reduced by evenly forming the silicon oxide film on any plane orientation by the plasma processing device 100, the channel length modulation effect is reduced by forming a gate on a plurality of plane orientations to make a transistor with three-dimensional configuration, and therefore favorable electrical characteristics without variation between elements can be obtained. Also, the above three-dimensional configuration enables reduction of the element area.

Additionally, in the CMOS transistor with a three-dimensional structure, the element area can be considerably reduced in size while comprising balanced electrical characteristics.
The following shows a circuit configuration of a low noise amplifier to which a CMOS transistor comprising an n-channel MOS transistor and a p-channel MOS transistor, which are three-dimensional MOS transistors formed using the gate insulator thin film formation method, is applied.

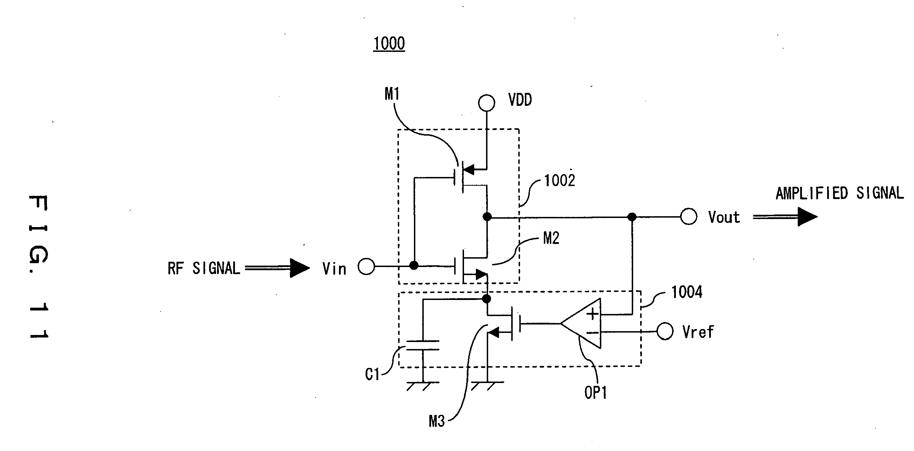

Fig. 11 is a circuit diagram of a low noise amplifier configured by applying the above CMOS transistors.
As shown in Fig. 11, the circuit 1000 of a low noise amplifier comprises a CMOS transistor 1002, in which a p-channel MOS transistor M1 and an n-channel MOS transistor M2 are combined, and an operating point determination circuit 1004, in which a condenser C1, an n-channel MOS transistor M3, and an operational amplifier OP1 are combined.

First, in the CMOS transistor 1002, a common input voltage (for example, input voltage, which varies according to a carrier wave received by an antenna) is applied to the gates of the p-channel MOS transistor M1 and the n-channel MOS transistor M2. The p-channel MOS transistor M1 and the n-channel MOS transistor M2 are made to function as signal amplifiers. Further, in the present circuit, in order to acquire high voltage gain, a voltage source VDD is connected to the drain of the p-channel MOS transistor M1. Then, the amplified voltage of the input voltage is output to the source of the p-channel MOS transistor M1 and the drain of the n-channel MOS transistor M2.

On the other hand, the operating point determination circuit 1004 is, because the bias current and the drain voltage of the p-channel MOS transistor M1 are susceptible to the source voltage VDD, inserted between the source of the p-channel MOS transistor M1 and the n-channel MOS transistor M2, and the amplified voltage is controlled based on a reference voltage (Vref) so that the thermal noise and the 1/f noise are reduced by controlling gₘ, determining its operating point. The C1 is inserted in order to reduce the thermal noise.

In the CMOS transistor 1002 shown in the present circuit, the 1/f noise generated from the p-channel MOS transistor M1 and the n-channel MOS transistor M2 is considerably reduced. When both MOS transistors (M1 and M2) have the same element areas, the same electrical characteristics can be acquired without variation. Moreover, parasitic capacitance of the p-channel MOS transistor and the n-channel MOS transistor can be matched to each other, and therefore the difference between rise and decay characteristics of the drain current in response to the voltage between the gate and the source can be significantly eliminated.

In the above circuit, influence of not only the 1/f noise but also of the signal distortion, caused by variation in the electrical characteristics of the transistor element, can be substantially improved, and it is possible to configure a low noise amplifier with a lower noise level and higher gain level than was previously possible.

For this reason, a separately configured circuit for reducing the 1/f noise or the signal distortion generated in the low noise amplifier is not required, allowing the low noise amplifier to be reduced in size.
The low noise amplifier of an embodiment of the present invention can also be applied to a circuit of the direct conversion receiving system.

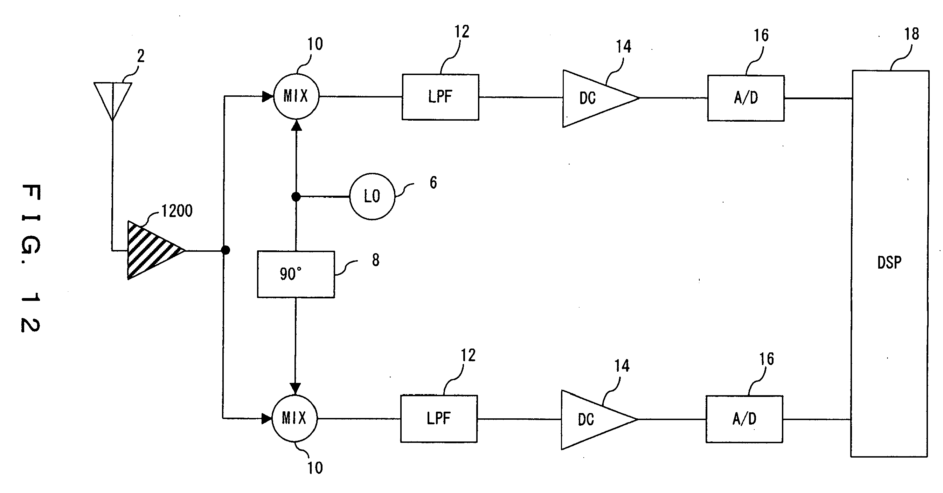

Fig. 12 is an example of the application of the low noise amplifier to a circuit of the direct conversion receiving system. As shown in Fig. 12, the low noise amplifier 1200, which is an embodiment of the present invention, can be inserted at the position of the low noise amplifier 4 explained in the Background Art. (An explanation of the configuration and operation of the direct conversion receiving system is omitted herein as details are explained in the Background Art using Fig. 1)

As shown above, when the configuration of the low noise amplifier of an embodiment of the present invention is applied to the direct conversion receiving system, first, reduction of the 1/f noise in the low noise amplifier with gain in the direct conversion receiving system, and then, the S/N ratio of a demodulated signal in later stages is improved, allowing the signal demodulated in the direct conversion receiving system to have high quality. The application of the low noise amplifier of an embodiment of the present invention allows reduction in size of the direct conversion receiver for a circuit for reducing the 1/f noise and the signal distortion, and therefore additional circuit is not required to be configured in later stage circuits.

By applying the three-dimensional CMOS transistor, a low noise amplifier or a direct conversion receiver with features of reduced size, low electrical power consumption, and high performance can be configured.
It is also possible to apply the low noise amplifier of an embodiment of the present invention to a receiver of a super heterodyne system. In the super heterodyne system, in order to control the influence of noise, an approach taken is that the gain is increased once to 80dB etc. is decreased to 60dB for example in the IF stage and it is increased back to 80dB in the later stage by using bipolar etc. However, the application of the low noise amplifier of an embodiment of the present invention enables reduction of the noise influence, and thus it is possible to improve the decrease in gain in the IF stage and also improve the S/N ratio.

The embodiment of the present invention was explained by applying a heretofore known gate insulator thin film formation technique, which operates most suitably for noise reduction of a low noise amplifier, as a formation method of the gate insulator; however it is not limited to the gate insulator thin film formation technique but other appropriate gate insulator formation methods may be used according to the use of the low noise amplifier.

As described above, according to an embodiment of the present invention, it is possible to largely improve the 1/f noise generation characteristics and variation of electrical characteristics of each transistor element in a low noise amplifier.
Consequently, the 1/f noise and the signal distortion applied to the output signal by the low noise amplifier can be significantly reduced, and therefore a circuit for compensating for the reduction of the amplitude is no longer of necessity, allowing a reduction in size.

In addition, configuration of a low noise amplifier comprising a CMOS transistor, in which the current driving capacities of the p-channel MOS transistor and the n-channel MOS transistor agree with each other, reduces the signal distortion in the output signal, and thus, a low noise amplifier with the features of small size, low electrical power consumption, and high performance can be realized.

The direct conversion receiver comprising the low noise amplifier of the present invention is reduced in size as well, and the S/N ratio is improved enhancing quality of the demodulated signal.
The present invention is to be construed as embodying many variations without departing from the scope and spirit thereof. Accordingly, it is to be understood that descriptions herein are proffered by way of example to facilitate comprehension of the invention and should not be construed to limit the scope. The scope of the present invention is presented by the scope of claims and should not be limited by the descriptions. In addition, all modifications and alternative constructions, which fall into the equivalents of the scope of the claims, fairly fall within the scope of the present invention.

## Claims

1. A low noise amplifier with a MIS transistor, which amplifies an input signal suppressing the noise to a low level, wherein the MIS transistor comprises:
a semiconductor substrate for comprising a first crystal plane as a principal plane;
a semiconductor structure, formed as a part of the semiconductor substrate, for comprising a pair of sidewall planes defined by the second crystal plane different from the first crystal plane and a top plane defined by the third crystal plane different from the second crystal plane;
a gate insulator for covering the principal plane, the sidewall planes and the top plane of uniform thickness;
a gate electrode for continuously covering the principal plane, the sidewall planes and the top plane on top of the gate insulator; and
a single conductivity type diffusion region formed in one side and other side of the gate electrode in the semiconductor substrate and the semiconductor structure and continuously extending along the principal plane, the sidewall planes and the top plane.

2. A low noise amplifier with a MIS transistor, which amplifies an input signal suppressing the noise to a low level, wherein the MIS transistor comprises:
a semiconductor substrate comprising a projecting part of which the surfaces are at least two different crystal planes on a principal plane;
a gate insulator for covering at least a part of each of said at least two different crystal planes constituting the surface of the projecting part;
a gate electrode comprised by the gate insulator so as to be electrically insulated from the semiconductor substrate, and comprised on each of said at least two different crystal planes constituting the surface of the projecting part; and
a single conductivity type diffusion region formed in the projecting part facing each of said at least two different crystal planes constituting the surface of the projecting part and individually formed on both sides of the gate electrodes.

3. A low noise amplifier with a MIS transistor, which amplifies an input signal suppressing the noise to a low level, wherein the MIS transistor is a three-dimensional MIS transistor comprising:
a semiconductor substrate comprising at least two crystal planes;
a gate insulator formed on at least two of the crystal planes on the semiconductor substrate; and
a gate electrode formed on the semiconductor substrate sandwiching the gate insulator,
in which when voltage is applied to the gate electrode, a channel width of a channel formed in the semiconductor substrate along with the gate insulator is represented by summation of each channel width of the channels individually formed on said at least two crystal planes.

4. The low noise amplifier according to any of claim 1 to claim 3, wherein the MIS transistor is **characterized in:**
**that** the semiconductor substrate is a silicon substrate; and
**that** a gate insulator on a surface of the silicon substrate, is formed by removing hydrogen in a way that the surface of the silicon substrate is exposed to plasma of a prescribed inert gas, and the hydrogen content at an interface of the silicon substrate and the gate insulator is 10¹¹/cm² or less in units of surface density.

5. The low noise amplifier according to claim 4, wherein said at least two crystal planes are any two different crystal planes from a (100) plane, a (110) plane and a (111) plane.

6. A low noise amplifier, comprising a CMOS transistor configured in an n-channel MOS transistor and a p-channel MOS transistor, wherein at least one of the n-channel MOS transistor or the p-channel MOS transistor comprises the MIS transistor of the low noise amplifier according to claim 1 or claim 3.

7. The low noise amplifier according to claim 6 wherein element areas and current driving capacities of the p-channel MOS transistor and the n-channel MOS transistor closely agree with each other.

8. The low noise amplifier according to claim 6 wherein
input voltage based on the input signal is applied to both the gate of the p-channel MOS transistor and the gate of the n-channel MOS transistor,
a voltage source is configured at the drain side of the p-channel MOS transistor,
the source of the p-channel MOS transistor and the drain of the n-channel MOS transistor are mutually connected,
a direct current feedback circuit for operating point determination is connected between the source and the drain of the n-channel MOS transistor, and
voltage, present in the connection line mutually connecting the source of the p-channel MOS transistor and the drain of the n-channel MOS transistor, being output as the amplified voltage of the input voltage.

9. The low noise amplifier according to claim 7 wherein
input voltage based on the input signal is applied to both the gate of the p-channel MOS transistor and the gate of the n-channel MOS transistor,
a voltage source is configured at the drain side of the p-channel MOS transistor,
the source of the p-channel MOS transistor and the drain of the n-channel MOS transistor are mutually connected,
a direct current feedback circuit for operating point determination is connected between the source and the drain of the n-channel MOS transistor, and
voltage, present in the connection line mutually connecting the source of the p-channel MOS transistor and the drain of the n-channel MOS transistor, being output as the amplified voltage of the input voltage.

10. The low noise amplifier according to any of claim 1 to claim 3, which is used in a direct conversion receiving system.
